# EUROPEAN PATENT APPLICATION

(11) **EP 3 418 902 A2**
(43) Date of publication of application: **26.12.2018**
(21) Application number: 18169189.0
(22) Date of filing: 25.04.2018
(51) Int. Cl.: G06F 13/40

(54) **MULTI-RANK TOPOLOGY OF MEMORY MODULE AND ASSOCIATED CONTROL METHOD**

(30) Priority: 03.05.2017 US 201762500544 P; 23.04.2018 US 201815959303
(71) Applicant: MediaTek Inc., Hsin-chu 300 (TW)
(72) Inventor: WU, Chung-Hwa, 702 Tainan City (TW); CHEN, Shang-Pin, 302 Hsinchu County (TW)
(74) Representative: Haseltine Lake LLP

(57) **Abstract**

The present invention provides a memory module wherein the memory module includes a plurality of memory devices having at least a first memory device and a second memory device, and the first memory device comprises a first termination resistor, and the second memory device comprises a second termination resistor. In the operations of the memory module, when the first memory device is accessed by a memory controller and the second memory device is not accessed by the memory controller, the first termination resistor is controlled to not provide impedance matching for the first memory device, and the second termination resistor is controlled to provide impedance matching for the second memory device.

## Description

This application claims the priority of US Provisional Application No. 62/500,544, filed on May 3th, 2017.

### Background

In a multi-rank dynamic random access memory (DRAM) module, the signal quality may be worsened because of the increasing loading. Therefore, the DRAM module generally includes on-die termination (ODT) for impedance matching of signal lines, and signal distortion can be reduced by using the ODT to improve the signal quality. Conventionally, the on-die termination is preferred to have lower impedance, however, this low impedance setting may cause an over-damped issue, that is a rising time or a falling time may increase, causing a problem to the following signal processing.

### Summary

It is therefore an objective of the present invention to provide under-damped ODT control mechanism for a multi-rank DRAM module, to solve the above-mentioned problems.

According to one embodiment of the present invention, a memory module is provided, wherein the memory module includes a plurality of memory devices having at least a first memory device, and the first memory device comprises a first termination resistor. In the operations of the memory module, when the first memory device is accessed by a memory controller, the first termination resistor is controlled to not provide impedance matching for the first memory device.

According to another embodiment of the present invention, a control method of a memory module is disclosed, wherein the memory module comprises at least a first memory device, the first memory device comprises a first termination resistor, and the control method comprises: when the first memory device is accessed by a memory controller, controlling the first termination resistor to not provide impedance matching for the first memory device.

According to another embodiment of the present invention, a memory module is provided, wherein the memory module comprises a plurality of memory devices comprising at least a first memory device and a second memory device, wherein the first memory device comprises a first variable termination resistor, and the second memory device comprises a second variable termination resistor. In the operations of the memory module, when the first memory device is accessed by a memory controller and the second memory device is not accessed by the memory controller, both the first variable termination resistor and the second variable termination resistor are controlled to provide impedance matching, and a resistance of the first variable termination resistor is greater than a resistance of the second variable termination resistor.

According to another embodiment of the present invention, a control method of a memory module, wherein the memory module comprises at least a first memory device and a second memory device, the first memory device comprises a first variable termination resistor, and the second memory device comprises a second variable termination resistor, and the control method comprises: when the first memory device is accessed by a memory controller and the second memory device is not accessed by the memory controller, controlling both the first variable termination resistor and the second variable termination resistor to provide impedance matching, wherein a resistance of the first variable termination resistor is greater than a resistance of the second variable termination resistor.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a memory system according to one embodiment of the present invention.
FIG. 2 shows the DRAM device according to one embodiment of the present invention.
FIG. 3 is a diagram illustrating an ODT control according to a first embodiment of the present invention.
FIG. 4 is a timing diagram of signals of the embodiment shown in FIG. 3 according to one embodiment of the present invention.
FIG. 5 is a diagram illustrating an ODT control according to a second embodiment of the present invention.
FIG. 6 is a timing diagram of signals of the embodiment shown in FIG. 5 according to one embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ..." The terms "couple" and "couples" are intended to mean either an indirect or a direct electrical connection. Thus, if a first device couples to a second device, that connection may be through a direct electrical connection, or through an indirect electrical connection via other devices and connections.

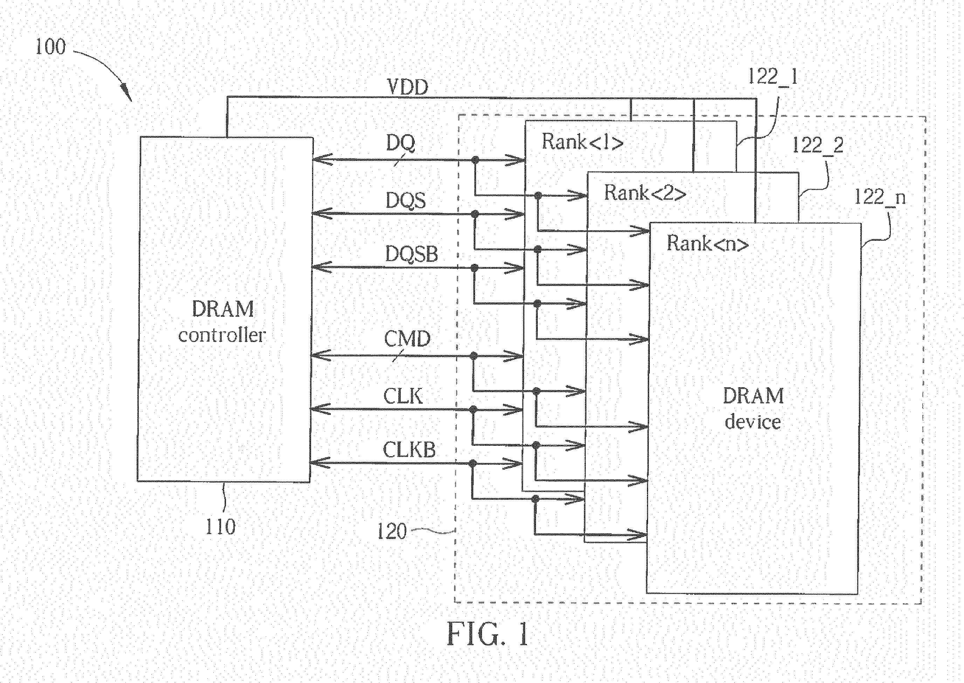

FIG. 1 is a diagram illustrating a memory system 100 according to one embodiment of the present invention. In this embodiment, the memory system 100 is a volatile memory system such as a DRAM system. As shown in FIG. 1, the memory system 100 comprises a DRAM controller 110 and a DRAM module 120 supplied by a supply voltage VDD, where the memory module 120 comprises a plurality of DRAM devices 122_1-122_n, wherein the DRAM devices 122_1-122_n. In this embodiment, the memory controller 110 and the memory module 120 are connected via a plurality of connection lines, where the connection lines are used to transmit a plurality of bi-directional data signals DQs, a data strobe signal DQS, an inverted data strobe signal DQSB, a plurality of command signals CMDs, a clock signal CLK, and an inverted clock signal CLKB.

In this embodiment, each of the DRAM devices 122_1-122_n may comprise a plurality of DRAM chips, and the DRAM devices 122_1-122_n belong to different ranks (e.g. Rank<1>-Rank<n> shown in FIG. 1) of the DRAM module 120. The DRAM devices 122_1-122_n share the same connection lines, that is, only one of the DRAM devices 122_1-122_n is accessed by the DRAM controller 110 during an access period.

When the memory system 100 is implemented by the DRAM system, the command signals may comprise at least a row address strobe, a column address strobe, and a write enable signal. In addition, the data strobe signal DQS and the inverted data strobe signal DQSB are arranged for data signal (DQs) latch in the memory module 120, and the clock signal CLK and the inverted clock signal CLKB are arranged for command signal (CMDs) latch in the memory module 120, and a frequency of the data strobe signal DQS is greater than or equal to a frequency of the clock signal CLK. For example, the memory module 120 may use the data strobe signal DQS and the inverted data strobe signal DQSB to sample and store the data signal for subsequent signal processing, and the memory module 120 may use the clock signal CLK and the inverted clock signal CLKB to sample and store the command signal for subsequent signal processing.

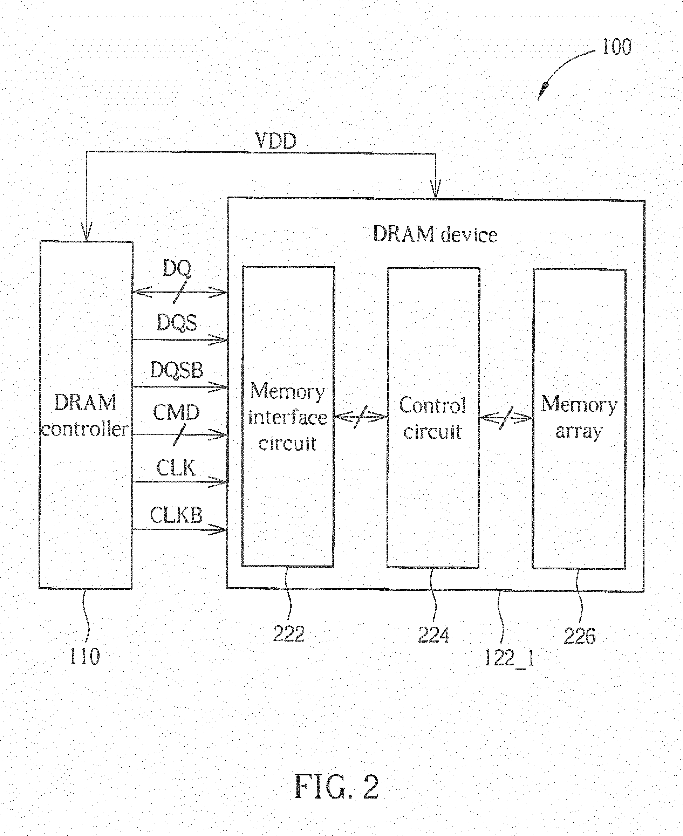

FIG. 2 shows the DRAM device 122_1 according to one embodiment of the present invention. As shown in FIG. 2, the DRAM device 122_1 comprises a memory interface circuit 222, a control circuit 224 and a memory array 226. In the operations of the memory system 100, the memory controller 110 is arranged to receive a request from a host or a processor, and to transmit at least a portion of the data signal DQ, command signals CMDs, the clock signal CLK, the inverted clock signal CLKB, the data strobe signal DQS and the inverted data strobe signal DQSB to access the memory module 120. In addition, the memory controller 110 may comprise associated circuits, such as an address decoder, a processing circuit, a write/read buffer, a control logic and an arbiter, to perform the related operations. The memory interface circuit 222 comprises a plurality of pads/pins and associated receiving circuit, and the memory interface circuit is arranged to receive the data signal DQs, the data strobe signal DQS, the inverted data strobe signal DQSB, the command signals CMDs, the clock signal CLK, and the inverted clock signal CLKB from the memory controller 110, and to selectively output the received signals to the control circuit 224. The control circuit 224 may comprise a read/write controller, a row decoder and a column decoder, and the control circuit 224 is arranged to receive the signals from the memory interface circuit 222 to access the memory array 226.

Since the embodiments of the present invention focus on the ODT control, detailed descriptions about the other elements are therefore omitted here.

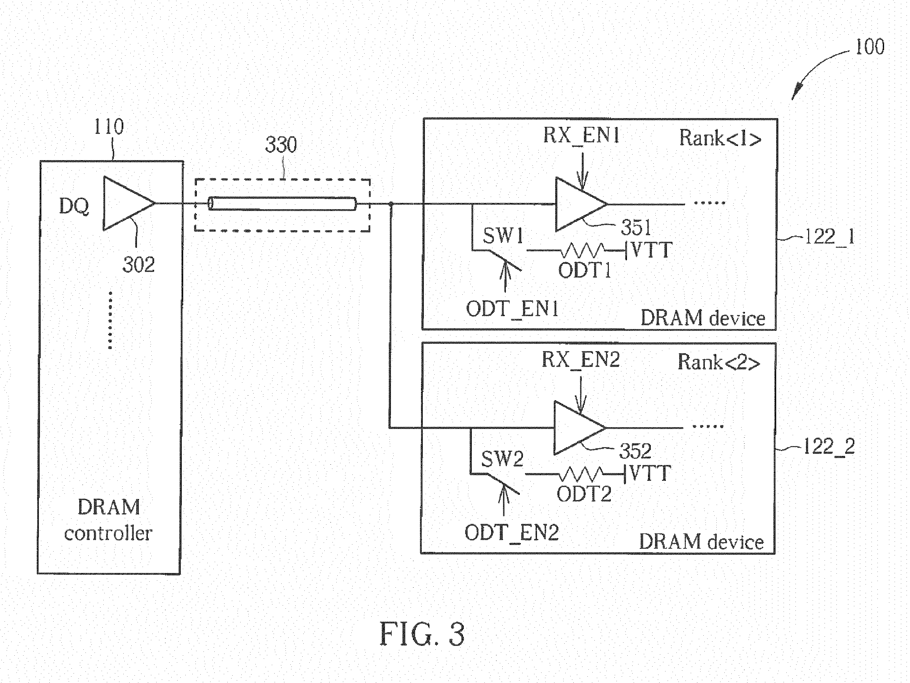

FIG. 3 is a diagram illustrating an ODT control according to a first embodiment of the present invention. As shown in FIG. 3, the DRAM device 122_1 comprises a plurality of receivers (a receiver 351 is shown as an example), a termination resistor ODT1 and a switch SW1, wherein one node of the termination resistor ODT1 is coupled to a reference voltage VTT, and the other node of the termination resistor ODT1 is selectively connected to an input terminal of the receiver 351 to provide impedance matching; and the DRAM device 122_2 comprises a receiver 352, a termination resistor ODT2 and a switch SW2, wherein one node of the termination resistor ODT2 is coupled to the reference voltage VTT, and the other node of the termination resistor ODT2 is selectively connected to an input terminal of the receiver 352 to provide impedance matching. In this embodiment, when the memory controller 110 sends a command signal that requires accessing one of the DRAM device such as the DRAM device 122_1, such as a read command, a write command or a masked write command, the control circuit 224 of the DRAM device 122_1 refers to the received command signal to generate an ODT enable signal ODT_EN1 to turn off the switch SW1, that is, the termination resistor ODT1 is not connected to the input terminal of the receiver 351, and the termination resistor ODT1 does not provide the impedance matching for the channel 330 and the receiver 351; the control circuit 224 of the DRAM device 122_1 further generates a receiver enable signal RX_EN1 to enable the receiver 351 to buffer the data signal DQ from a driver 302 within the DRAM controller 110 via a channel 330, and sends the data signal DQ to the following circuits. In addition, the control circuit 224 of the DRAM device 122 2 refers to the received command signal to generate an ODT enable signal ODT_EN2 to turn on the switch SW2, that is, the termination resistor ODT2 is connected to the input terminal of the receiver 352, and the termination resistor ODT provides the impedance matching for the channel 330 and the receiver 352; the control circuit 224 of the DRAM device 122_2 further generates a receiver enable signal RX_EN2 to disable the receiver 352, that is, the receiver 352 does not receive the data signal DQ.

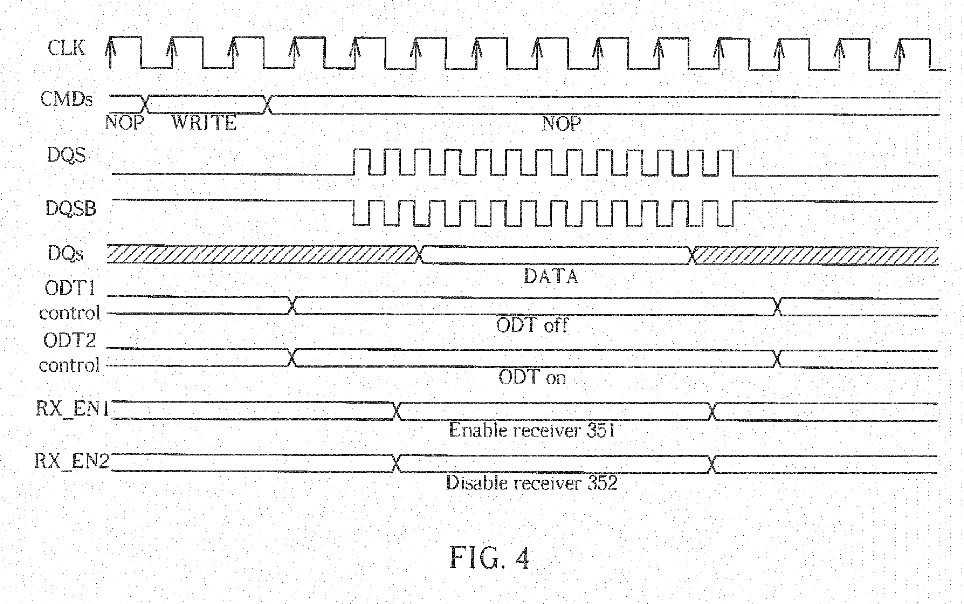

FIG. 4 is a timing diagram of signals of the embodiment shown in FIG. 3 according to one embodiment of the present invention. As shown in FIG. 4, initially when the memory controller 110 does not send the command signal to the memory module 120, or the memory controller 110 sends the command signal that does not require using the data strobe signal DQS and the inverted data strobe signal DQSB during the command operation (that is "NOP" shown in FIG. 4), the data strobe signal DQS is at a low voltage level, and the inverted data strobe signal DQSB is at a high voltage level. Then, when the memory controller 110 receives a request from a host or a processor to write data into the DRAM device 122_1, the memory controller 110 sends a write command to the DRAM device 122_1. After receiving the write command, the DRAM device 122_1 turns off the ODT operation, then the memory controller 110 enables the data strobe signal DQS and the inverted data strobe signal DQSB (i.e. the data strobe signal DQS and the inverted data strobe signal DQSB are toggled), then the receiver 351 is enabled to receive the data signals DQs from the memory controller 110, and the contents within the data signals DQs is written into the DRAM device 122_1 by using the data strobe signal DQS and the inverted data strobe signal DQSB. Meanwhile, the DRAM device 122_2 turns on the ODT operation and turns off the receiver 352. After the data is written into the memory module 120 successfully, the memory controller 110 stop outputting the data strobe signal DQS and the inverted data strobe signal DQSB.

In one embodiment that the memory system 100 has more than two DRAM devices, only the DRAM device that is accessed by the DRAM controller 110 needs to disable the ODT function, and the ODT function of all the other DRAM devices are enabled.

In the embodiment of FIG. 3 and FIG. 4, because the DRAM device 122_1 that is accessed by the DRAM controller 110 does not enable its ODT function, the prior art over-damped issue can be avoided, that is the rising time and the falling time can be shortened. In addition, because the other DRAM device 122_2 that is not accessed by the DRAM controller 110 enable its ODT function for providing impedance matching for the channel 330, the DQ signal on the channel 330 may not worsened due to the disabled ODT function of the DRAM device 122_1.

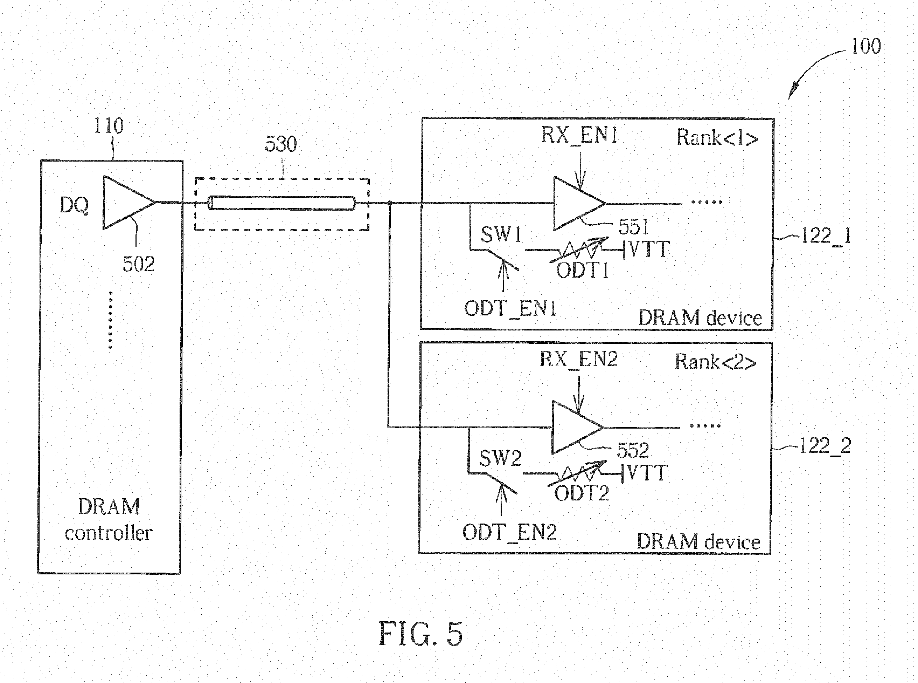

FIG. 5 is a diagram illustrating an ODT control according to a second embodiment of the present invention. As shown in FIG. 5, the DRAM device 122_1 comprises a receiver 551, a variable termination resistor ODT1 and a switch SW1, wherein one node of the variable termination resistor ODT1 is coupled to the reference voltage VTT, and the other node of the variable termination resistor ODT1 is selectively connected to an input terminal of the receiver 551 to provide impedance matching; and the DRAM device 122_2 comprises a receiver 552, a variable termination resistor ODT2 and a switch SW2, wherein one node of the variable termination resistor ODT2 is coupled to the reference voltage VTT, and the other node of the variable termination resistor ODT2 is selectively connected to an input terminal of the receiver 552 to provide impedance matching. In this embodiment, each of the variable termination resistor ODT1 and the variable termination resistor ODT2 can be controlled to have the impedances such as 240ohm, 120ohm, 80ohm, 60ohm, 40phm, 30ohm. In this embodiment, when the memory controller 110 sends a command signal that requires accessing one of the DRAM device such as the DRAM device 122_1, such as a read command, a write command or a masked write command, the control circuit 224 of the DRAM device 122_1 refers to the received command signal to generate an ODT enable signal ODT_EN1 to turn on the switch SW1, that is the variable termination resistor ODT1 is connected to the input terminal of the receiver 551, and the variable termination resistor ODT1 is set to have a higher impedance such as 240ohm; the control circuit 224 of the DRAM device 122_1 further generates a receiver enable signal RX_EN1 to enable the receiver 551 to buffer the data signal DQ from a driver 502 within the DRAM controller 110 via a channel 530, and sends the data signal DQ to the following circuits. In addition, the control circuit 224 of the DRAM device 122 2 refers to the received command signal to generate an ODT enable signal ODT_EN2 to turn on the switch SW2, that is the variable termination resistor ODT2 is connected to the input terminal of the receiver 552, and the variable termination resistor ODT2 is set to have a higher impedance such as 40ohm; the control circuit 224 of the DRAM device 122_2 further generates a receiver enable signal RX_EN2 to disable the receiver 552, that is the receiver 552 does not receive the data signal DQ.

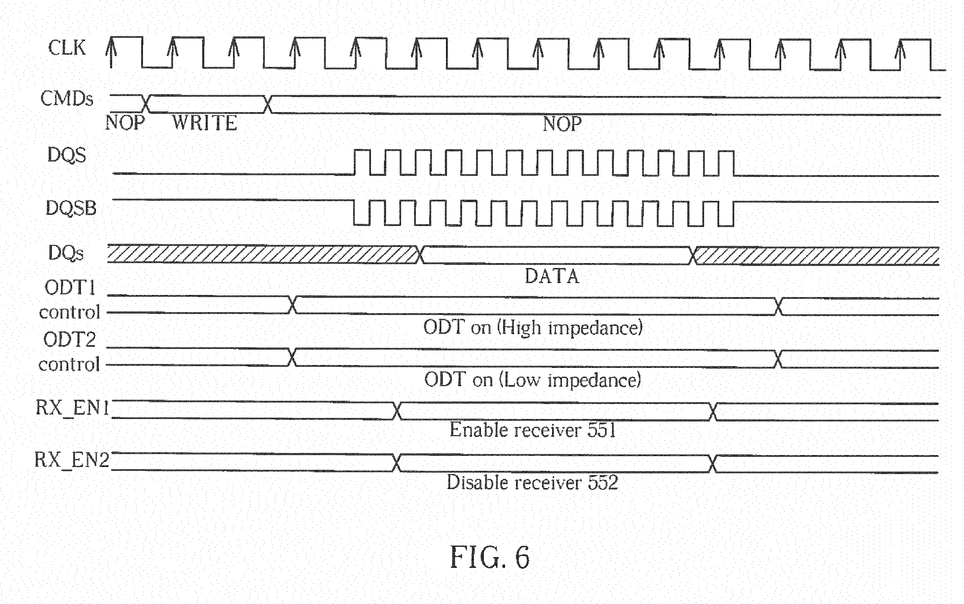

FIG. 6 is a timing diagram of signals of the embodiment shown in FIG. 5 according to another embodiment of the present invention. As shown in FIG. 6, initially when the memory controller 110 does not send the command signal to the memory module 120, or the memory controller 110 sends the command signal that does not require using the data strobe signal DQS and the inverted data strobe signal DQSB during the command operation (that is "NOP" shown in FIG. 6), the data strobe signal DQS is at a low voltage level, and the inverted data strobe signal DQSB is at a high voltage level. Then, when the memory controller 110 receives a request from a host or a processor to write data into the DRAM device 122_1, the memory controller 110 sends a write command to the DRAM device 122_1. After receiving the write command, the DRAM device 122_1 turns on the ODT operation and sets the variable termination resistor ODT1 to have the higher impedance, then the memory controller 110 enables the data strobe signal DQS and the inverted data strobe signal DQSB (i.e. the data strobe signal DQS and the inverted data strobe signal DQSB are toggled), then the receiver 551 is enabled to receive the data signals DQs from the memory controller 110, and the contents within the data signals DQs is written into the DRAM device 122_1 by using the data strobe signal DQS and the inverted data strobe signal DQSB. Meanwhile, the DRAM device 122_2 turns on the ODT operation and turns off the receiver 552, where the variable termination resistor ODT2 is set to have lower impedance. After the data is written into the memory module 120 successfully, the memory controller 110 stop outputting the data strobe signal DQS and the inverted data strobe signal DQSB.

In one embodiment that the memory system 100 has more than two DRAM devices, only the DRAM device that is accessed by the DRAM controller 110 needs to set the higher impedance ODT, and the variable termination resistors of all the other DRAM devices are all set to have lower impedance.

In the embodiment of FIG. 5 and FIG. 6, because the DRAM device 122_1 that is accessed by the DRAM controller 110 enable the ODT function with the higher impedance, the prior art over-damped issue can be avoided, that is the rising time and the falling time can be shortened. In addition, because the other DRAM device 122_2 that is not accessed by the DRAM controller 110 enable its ODT function with the lower impedance for providing impedance matching for the channel 530, the DQ signal on the channel 530 may not worsened due to the disabled ODT function of the DRAM device 122_1.

Briefly summarize, in the ODT control mechanism of the present invention, the memory device that is access by the memory controller is controlled to disable the ODT function or enable the ODT function with higher impedance, and the memory device that is not accessed by the memory controller is controlled to enable the ODT function with lower impedance. Hence, the prior art over-damped issue can be improved (that is, the ODT control mechanism can be regarded as the under-damped PDT control) while maintaining the signal quality.

Those skilled in the art will readily observe that numerous modifications and alterations of the device and method may be made while retaining the teachings of the invention. Accordingly, the above disclosure should be construed as limited only by the metes and bounds of the appended claims.

The present invention may also be defined by means of the following numbered clauses:
1. A memory module, comprising:
   a plurality of memory devices comprising at least a first memory device and, wherein the first memory device comprises a first termination resistor;
   wherein when the first memory device is accessed by a memory controller, the first termination resistor is controlled to not provide impedance matching for the first memory device.
2. The memory module of clause 1, wherein the plurality of memory devices further comprises a second memory device, the second memory device comprises a second termination resistor, and when the first memory device is accessed by the memory controller and the second memory device is not accessed by the memory controller, the first termination resistor is controlled to not provide the impedance matching for the first memory device, and the second termination resistor is controlled to provide impedance matching for the second memory device.
3. The memory module of clause 2, wherein the first memory device further comprises a first receiver, and the second memory device further comprises a second receiver; and when the first memory device is accessed by the memory controller and the second memory device is not accessed by the memory controller, the first termination resistor is controlled to disconnect to an input terminal of the first receiver of the first memory module, and the second termination resistor is controlled to connect to an input terminal of the second receiver of the second memory module.
4. The memory module of clause 3, wherein when the first memory device is accessed by the memory controller and the second memory device is not accessed by the memory controller, the first receiver is enabled to receive a data signal from the memory controller while the first termination resistor is disconnected to the input terminal of the first receiver, and the second receiver is disabled so as to not receive any data signal from the memory controller and the second termination resistor is connected to the input terminal of the second receiver.
5. The memory module of clause 2, wherein the memory module is a dynamic random access memory (DRAM) module, the memory controller is a DRAM controller, the first memory device and the second memory device belong to different ranks, and each of the first termination resistor and the second termination resistor is an on-die termination resistor.
6. The memory module of clause 5, wherein the first memory device further comprises a first receiver, and the second memory device further comprises a second receiver; and when the first memory device receive a write command from the DRAM controller, the first receiver is enabled to receive a data signal from the DRAM controller while the first termination resistor is disconnected to an input terminal of the first receiver, and the second receiver is disabled so as to not receive any data signal from the DRAM controller and the second termination resistor is connected to the input terminal of the second receiver.
7. A control method of a memory module, wherein the memory module comprises at least a first memory device, the first memory device comprises a first termination resistor, and the control method comprises:
   when the first memory device is accessed by a memory controller, controlling the first termination resistor to not provide impedance matching for the first memory device.
8. The control method of clause 7, wherein the plurality of memory devices further comprises a second memory device, the second memory device comprises a second termination resistor, and the control method further comprises:
   when the first memory device is accessed by the memory controller and the second memory device is not accessed by the memory controller, controlling the first termination resistor to not provide the impedance matching for the first memory device, and controlling the second termination resistor to provide impedance matching for the second memory device.
9. The control method of clause 8, wherein the first memory device further comprises a first receiver, the second memory device further comprises a second receiver, and the step of controlling the first termination resistor and the second termination resistor comprises:
   when the first memory device is accessed by the memory controller and the second memory device is not accessed by the memory controller, controlling the first termination resistor to disconnect to an input terminal of the first receiver of the first memory module, and controlling the second termination resistor to connect to an input terminal of the second receiver of the second memory module.
10. The control method of clause 9, wherein the step of controlling the first termination resistor and the second termination resistor comprises:
   when the first memory device is accessed by the memory controller and the second memory device is not accessed by the memory controller, enabling the first receiver to receive a data signal from the memory controller while the first termination resistor is disconnected to the input terminal of the first receiver; and disabling the second receiver to not receive any data signal from the memory controller and the second termination resistor is connected to the input terminal of the second receiver.
11. The control method of clause 8, wherein the memory module is a dynamic random access memory (DRAM) module, the memory controller is a DRAM controller, the first memory device and the second memory device belong to different ranks, and each of the first termination resistor and the second termination resistor is an on-die termination resistor.
12. The control method of clause 11, wherein the first memory device further comprises a first receiver, the second memory device further comprises a second receiver, and the step of controlling the first termination resistor and the second termination resistor comprises:
   when the first memory device receive a write command from the DRAM controller, enabling the first receiver to receive a data signal from the DRAM controller while the first termination resistor is disconnected to an input terminal of the first receiver; and disabling the second receiver to not receive any data signal from the DRAM controller and the second termination resistor is connected to the input terminal of the second receiver.
13. A memory module, comprising:
   a plurality of memory devices comprising at least a first memory device and a second memory device, wherein the first memory device comprises a first variable termination resistor, and the second memory device comprises a second variable termination resistor;
   wherein when the first memory device is accessed by a memory controller and the second memory device is not accessed by the memory controller, both the first variable termination resistor and the second variable termination resistor are controlled to provide impedance matching, and a resistance of the first variable termination resistor is greater than a resistance of the second variable termination resistor.
14. The memory module of clause 13, wherein the first memory device further comprises a first receiver, and the second memory device further comprises a second receiver; and when the first memory device is accessed by the memory controller and the second memory device is not accessed by the memory controller, the first variable termination resistor is controlled to connect to an input terminal of the first receiver of the first memory module, and the second variable termination resistor is controlled to connect to an input terminal of the second receiver of the second memory module.
15. The memory module of clause 14, wherein when the first memory device is accessed by the memory controller and the second memory device is not accessed by the memory controller, the first receiver is enabled to receive a data signal from the memory controller while the first variable termination resistor is connected to the input terminal of the first receiver, and the second receiver is disabled so as to not receive any data signal from the memory controller and the second variable termination resistor is connected to the input terminal of the second receiver.
16. The memory module of clause 13, wherein the memory module is a dynamic random access memory (DRAM) module, the memory controller is a DRAM controller, the first memory device and the second memory device belong to different ranks, and each of the first variable termination resistor and the second variable termination resistor is an on-die termination resistor.
17. The memory module of clause 16, wherein the first memory device further comprises a first receiver, and the second memory device further comprises a second receiver; and when the first memory device receive a write command from the DRAM controller, the first receiver is enabled to receive a data signal from the DRAM controller while the first termination resistor is connected to an input terminal of the first receiver, and the second receiver is disabled so as to not receive any data signal from the DRAM controller and the second termination resistor is connected to the input terminal of the second receiver.
18. A control method of a memory module, wherein the memory module comprises at least a first memory device and a second memory device, the first memory device comprises a first variable termination resistor, and the second memory device comprises a second variable termination resistor, and the control method comprises:
   when the first memory device is accessed by a memory controller and the second memory device is not accessed by the memory controller, controlling both the first variable termination resistor and the second variable termination resistor to provide impedance matching, wherein a resistance of the first variable termination resistor is greater than a resistance of the second variable termination resistor.
19. The control method of clause 18, wherein the first memory device further comprises a first receiver, and the second memory device further comprises a second receiver, and the step of controlling the first variable termination resistor and the second variable termination resistor comprises:
   when the first memory device is accessed by the memory controller and the second memory device is not accessed by the memory controller, controlling the first variable termination resistor to connect to an input terminal of the first receiver of the first memory module, and controlling the second variable termination resistor to connect to an input terminal of the second receiver of the second memory module.
20. The control method of clause 19, wherein the step of controlling the first variable termination resistor and the second variable termination resistor comprises:
   when the first memory device is accessed by the memory controller and the second memory device is not accessed by the memory controller, enabling the first receiver to receive a data signal from the memory controller while the first variable termination resistor is connected to the input terminal of the first receiver, and disabling the second receiver to not receive any data signal from the memory controller while the second variable termination resistor is connected to the input terminal of the second receiver.
21. The control method of clause 18, wherein the memory module is a dynamic random access memory (DRAM) module, the memory controller is a DRAM controller, the first memory device and the second memory device belong to different ranks, and each of the first variable termination resistor and the second variable termination resistor is an on-die termination resistor.
22. The control method of clause 21, wherein the first memory device further comprises a first receiver, and the second memory device further comprises a second receiver, and the step of controlling the first variable termination resistor and the second variable termination resistor comprises:
   when the first memory device receive a write command from the DRAM controller, enabling the first receiver to receive a data signal from the DRAM controller while the first termination resistor is connected to an input terminal of the first receiver, and disabling the second receiver to not receive any data signal from the DRAM controller while the second termination resistor is connected to the input terminal of the second receiver.

## Claims

1. A memory module (120), comprising:
a plurality of memory devices (122_1-122_n)comprising at least a first memory device (122_1) and, wherein the first memory device (122_1) comprises a first termination resistor;
wherein when the first memory device (122_1) is accessed by a memory controller (110), the first termination resistor is controlled to not provide impedance matching for the first memory device (122_1).

2. The memory module (120) of claim 1, wherein the plurality of memory devices (122_1-122_n) further comprises a second memory device (122_2), the second memory device (122_2) comprises a second termination resistor, and when the first memory device (122_1) is accessed by the memory controller (110) and the second memory device (122_2) is not accessed by the memory controller (110), the first termination resistor is controlled to not provide the impedance matching for the first memory device (122_1), and the second termination resistor is controlled to provide impedance matching for the second memory device (122_2).

3. The memory module (120) of claim 2, wherein the first memory device (122_1) further comprises a first receiver, and the second memory device (122_2) further comprises a second receiver; and when the first memory device (122_1) is accessed by the memory controller (110) and the second memory device (122_2) is not accessed by the memory controller (110), the first termination resistor is controlled to disconnect to an input terminal of the first receiver of the first memory device (122_1), and the second termination resistor is controlled to connect to an input terminal of the second receiver of the second memory device (122_2).

4. The memory module (120) of claim 3, wherein when the first memory device (122_1) is accessed by the memory controller (110) and the second memory device (122_2) is not accessed by the memory controller (110), the first receiver is enabled to receive a data signal from the memory controller (110) while the first termination resistor is disconnected to the input terminal of the first receiver, and the second receiver is disabled so as to not receive any data signal from the memory controller (110) and the second termination resistor is connected to the input terminal of the second receiver.

5. A control method of a memory module (120), wherein the memory module (120) comprises at least a first memory device (122_1), the first memory device (122_1) comprises a first termination resistor, and the control method comprises:
when the first memory device (122_1) is accessed by a memory controller (110), controlling the first termination resistor to not provide impedance matching for the first memory device (122_1).

6. The control method of claim 5, wherein the plurality of memory devices (122_1-122_n) further comprises a second memory device (122_2), the second memory device (122_2) comprises a second termination resistor, and the control method further comprises:
when the first memory device (122_1) is accessed by the memory controller (110) and the second memory device (122_2) is not accessed by the memory controller (110), controlling the first termination resistor to not provide the impedance matching for the first memory device (122_1), and controlling the second termination resistor to provide impedance matching for the second memory device (122_2).

7. The control method of claim 6, wherein the first memory device (122_1) further comprises a first receiver, the second memory device (122_2) further comprises a second receiver, and the step of controlling the first termination resistor and the second termination resistor comprises:
when the first memory device (122_1) is accessed by the memory controller (110) and the second memory device (122 2) is not accessed by the memory controller (110), controlling the first termination resistor to disconnect to an input terminal of the first receiver of the first memory device (122_1), and controlling the second termination resistor to connect to an input terminal of the second receiver of the second memory device (122_2).

8. The control method of claim 7, wherein the step of controlling the first termination resistor and the second termination resistor comprises:
when the first memory device (122_1) is accessed by the memory controller (110) and the second memory device (122_2) is not accessed by the memory controller (110), enabling the first receiver to receive a data signal from the memory controller (110) while the first termination resistor is disconnected to the input terminal of the first receiver; and disabling the second receiver to not receive any data signal from the memory controller (110) and the second termination resistor is connected to the input terminal of the second receiver.

9. A memory module (120), comprising:
a plurality of memory devices (122_1-122_n) comprising at least a first memory device (122_1) and a second memory device (122_2), wherein the first memory device (122_1) comprises a first variable termination resistor, and the second memory device (122_2) comprises a second variable termination resistor;
wherein when the first memory device (122_1) is accessed by a memory controller (110) and the second memory device (122_2) is not accessed by the memory controller (110), both the first variable termination resistor and the second variable termination resistor are controlled to provide impedance matching, and a resistance of the first variable termination resistor is greater than a resistance of the second variable termination resistor.

10. The memory module (120) of claim 9, wherein the first memory device (122_1) further comprises a first receiver, and the second memory device (122_2) further comprises a second receiver; and when the first memory device (122 1) is accessed by the memory controller (110) and the second memory device (122_2) is not accessed by the memory controller (110), the first variable termination resistor is controlled to connect to an input terminal of the first receiver of the first memory device (122_1), and the second variable termination resistor is controlled to connect to an input terminal of the second receiver of the second memory device (122_2).

11. The memory module (120) of claim 10, wherein when the first memory device (122_1) is accessed by the memory controller (110) and the second memory device (122 2) is not accessed by the memory controller (110), the first receiver is enabled to receive a data signal from the memory controller (110) while the first variable termination resistor is connected to the input terminal of the first receiver, and the second receiver is disabled so as to not receive any data signal from the memory controller (110) and the second variable termination resistor is connected to the input terminal of the second receiver.

12. A control method of a memory module (120), wherein the memory module (120) comprises at least a first memory device (122_1) and a second memory device (122 2), the first memory device (122_1) comprises a first variable termination resistor, and the second memory device (122_2) comprises a second variable termination resistor, and the control method comprises:
when the first memory device (122_1) is accessed by a memory controller (110) and the second memory device (122_2) is not accessed by the memory controller (110), controlling both the first variable termination resistor and the second variable termination resistor to provide impedance matching, wherein a resistance of the first variable termination resistor is greater than a resistance of the second variable termination resistor.

13. The control method of claim 12, wherein the first memory device (122_1) further comprises a first receiver, and the second memory device (122_2) further comprises a second receiver, and the step of controlling the first variable termination resistor and the second variable termination resistor comprises:
when the first memory device (122_1) is accessed by the memory controller (110) and the second memory device (122_2) is not accessed by the memory controller (110), controlling the first variable termination resistor to connect to an input terminal of the first receiver of the first memory device (122_1), and controlling the second variable termination resistor to connect to an input terminal of the second receiver of the second memory device (122_2).

14. The control method of claim 13, wherein the step of controlling the first variable termination resistor and the second variable termination resistor comprises:
when the first memory device (122_1) is accessed by the memory controller (110)and the second memory device (122 2) is not accessed by the memory controller (110), enabling the first receiver to receive a data signal from the memory controller (110) while the first variable termination resistor is connected to the input terminal of the first receiver, and disabling the second receiver to not receive any data signal from the memory controller (110) while the second variable termination resistor is connected to the input terminal of the second receiver.
